# EUROPEAN PATENT APPLICATION

(11) **EP 0 637 780 A1**
(43) Date of publication of application: **08.02.1995**
(21) Application number: 94112057.8
(22) Date of filing: 02.08.1994
(51) Int. Cl.: G03F 7/20

(54) **Exposure apparatus for photolithography**

(30) Priority: 03.08.1993 JP 191508/93
(71) Applicant: NEC CORPORATION, Tokyo (JP)
(72) Inventor: Ishii, Hiroyuki, c/o NEC Yamagata Ltd., Yamagata-shi, Yamagata (JP)
(74) Representative: Glawe, Delfs, Moll & Partner

(57) **Abstract**

The invention relates to an illuminating system in an exposure apparatus used in the fabrication of semiconductor devices to transfer patterns on a reticle to a substrate or wafer. The illuminating system includes a diaphragm (20) in which an aperture is formed to suitably shape a beam of illuminating light. According to the invention a liquid crystal display panel (22) is used as the principal part of the diaphragm, and the display panel is driven by a control unit (32) so as to display a black-and-white pattern having a white region (26) that is transparent to illuminating light and serves as a beam shaping aperture. According to the particulars of the reticle patterns a selection can be made from several different aperture patterns registered in the control unit. Therefore, when the reticle is changed the diaphragm does not need to be replaced by another.

## Description

### BACKGROUND OF THE INVENTION

This invention relates to an exposure apparatus which is used in the fabrication of semiconductor devices to reduce and transfer a pattern or patterns formed on a mask or reticle to a substrate or wafer coated with a photoresist layer, and more particularly to a diaphragm used in an illuminating system of the exposure apparatus.

In a conventional apparatus for the aforementioned purpose, commonly called a stepper, the illuminating system includes an aperture diaphragm for suitably shaping a beam of illuminating light at a section between an optical integrator to uniformalize the light beam and a condenser lens through which a reticle is illuminated. The shape of the aperture of the diaphragm is variously designed according to the particulars of the patterns on the reticle. For example, when the illuminating system is of an oblique incidence type it is suitable to employ an annular aperture, and the ratio of the inner diameter of the annular aperture to the outer diameter, called shape factor, is determined according to the pitch of the patterns on the reticle.

Therefore, when the reticle is changed to another reticle different in the particulars of patterns it is necessary to replace the aperture diaphragm by another. The replacement of the diaphragm is time-consuming and hence becomes a cause of lowering of the net working rate of the exposure apparatus.

### SUMMARY OF THE INVENTION

It is an object of the present invention to provide an improved exposure apparatus for use in the fabrication of semiconductor devices to project a reduced image of reticle patterns onto a substrate such as a silicon wafer, the improved apparatus having a novel diaphragm in which the shape of an aperture can be varied according to the particulars of the reticle patterns.

The invention provides an exposure apparatus having a light source which provides a beam of illuminating light, a diaphragm which is partly transparent so as to provide an aperture through which the light beam is shaped, a condenser lens arranged between the diaphragm and a reticle and a projection lens for projecting a reduced image of patterns on the reticle onto a substrate such as a wafer. According to the invention, the diaphragm comprises a liquid crystal display panel which can become partly opaque and partly transparent such that a transparent region of the panel serves as the aforementioned aperture and control means for driving the liquid crystal display panel so as to control the shape of the transparent region according to the particulars of the patterns on the reticle.

Thus, the invention resides in using a liquid crystal display panel as the principal part of the diaphragm. A liquid crystal display panel driven by a suitable control means can selectively display various patterns each of which has a transparent region of a desired shape defined by an opaque region or opaque regions. In this invention the transparent region is used as an aperture to shape the beam of illuminating light. It suffices to use a liquid crystal display panel that displays black-and-white patterns.

The primary merit of the diaphragm according to the invention is that the diaphragm panel itself does not need to be relaced by another even though the reticle is changed to another reticle different in the particulars of patterns. It is possible to register several different display patterns or aperture patterns in the control unit for driving the liquid crystal display panel and make a selection from the registered patterns by simply inputting the identification number of the selected pattern into an input unit provided to the control unit, and by doing so the shape of the aperture (transparent region of the liquid crystal display panel) can be varied very easily and quickly.

### BRIEF DESCRIPTION OF THE DRAWINGS

Fig. 1 is a schematic of an exposure apparatus embodying the invention; and
Fig. 2 is a schematic plan view of a diaphragm panel used in the exposure apparatus of Fig. 1 and shows an example of aperture patterns which the diaphragm panel can make.

### DESCRIPTION OF THE PREFERRED EMBODIMENTS

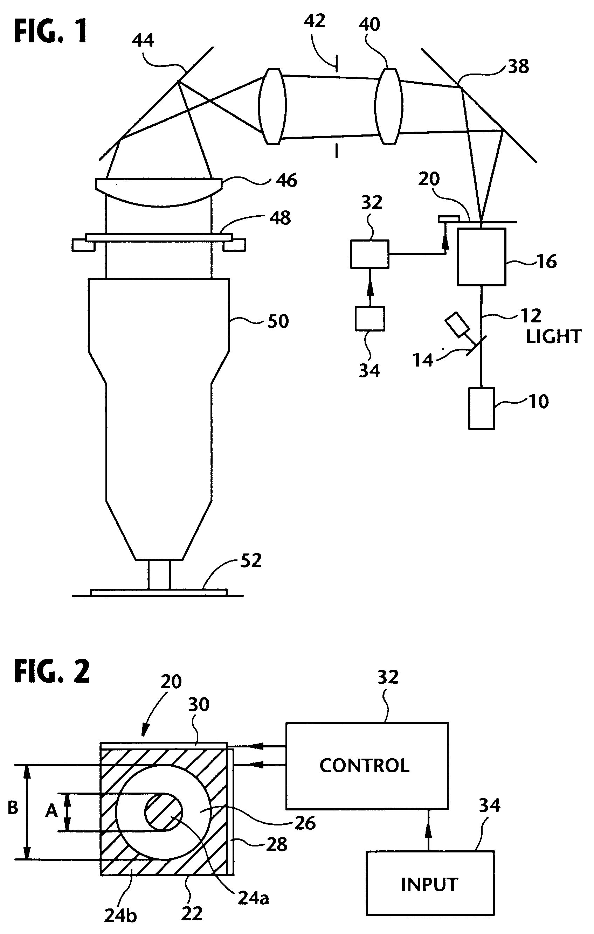

Fig. 1 shows an exposure apparatus in which the invention is embodied. The exposure apparatus is for projecting a reduced image of reticle patterns onto a wafer 52.

The exposure apparatus has an illuminating part 10 which includes a light source (not shown) and projects a beam of illuminating light 12. Through a shutter 14, the illuminating light enters an optical integrator 16 which serves the purpose of uniformalizing the distribution of luminous flux in the light beam 12. Next to the optical integrator 16 there is a diaphragm panel 20 according to the invention for desirably shaping the uniformalized light beam. Subsequent to the diaphragm panal 20, the exposrue apparatus has a mirror 38 to reflect the shaped beam, relay lenses 40, a reticle blind 42 to define the exposure area on a reticle 48, a mirror 44 to reflect the adjusted beam toward the reticle 48, a main condenser lens 46 through which the reticle 48 is illuminated and a projection lens 50 to form a reduced image of the reticle patterns on the wafer 52.

In this exposure apparatus the invention resides in the diaphragm panel 20. The other components of the apparatus are all conventional in both construction and arrangement.

Referring to Fig. 2, the principal part of the diaphragm panel 20 is a liquid crystal display panel 22 of X-Y matrix type. That is, the liquid crystal display panel 22 is constructed of a large number of liquid crystal cells that are confined between two transparent glass substrates so as to form a two-dimensional, X-Y matrix and provided with scanning electrodes and signalling electrodes in a crossing arrangement. A driving circuit 28 for the scanning electrodes is provided along one side of the display panel 22 and a driving circuit 30 for the signalling eletctrodes along an adjacent side. The driving circuits 28 and 30 are operated by a control unit 32 which has a memory bank for registering several kinds of aperture patterns to be selectively employed according to the particulars of the reticle patterns and usual controller components such as selector switches, frame memories, etc. An input unit 34 is used to make a selection from the aperture patterns registered in the control unit 32.

When the liquid crystal panel 22 displays a black-and-white pattern, the black region (or regions) of the panel becomes opaque to the illuminating light emerged from the optical integrator 16 in Fig. 1 and the white region (or regions) transparent. The black-and-white pattern can be so designed as to have a white region which serves as a beam shaping aperture of the diaphragm 20.

In the exposure apparatus of Fig. 1 the illuminating system is of an oblique incidence type. The oblique incidence illumination method is employed for the purpose of enhancing the resolving power and enlarging the focus depth, and to achieve such purpose it is suitable to form an annular aperture in the diaphragm 20. Fig. 2 shows an example of annular apertures. The liquid crystal display panel 22 is driven so as to display a black-and-white pattern consisting of a central black region 24a in a circular shape, a marginal black region 24b and an annular white region 26 between the two black regions 24a and 24b. The black regions 24a, 24b are opaque to the illuminating light, and the white region 26 is transparent. That is, the annular white region 26 serves as a beam-shaping aperture of the diaphragm panel 20. The shape factor of the annular aperture 26, viz. the ratio of the inner diameter A to the outer diameter B (ratio A/B), is suitably determined according to the pattern pitch of the employed reticle, and the angle of oblique incidence in the illuminating system is adjusted.

In the apparatus according to the invention several different values of the shape factor A/B of the annular aperture 26 of the diaphragm 20 are registered in the control unit 32, and any of the registered shape factors can be realized on the liquid crystal display panel 22 by simply inputting the identification number of that shape factor into the input unit 34.

## Claims

1. An exposure apparatus for projecting a reduced image of reticle patterns onto a substrate having a photosensitive surface, the apparatus having a light source which provides a beam of illuminating light, a diaphragm which is partly transparent so as to provide an aperture through which said beam is shaped, a condenser lens arranged between said diaphragm and a reticle and a projection lens for projecting a reduced image of patterns on said reticle onto said substrate,
characterized in that said diaphragm comprises a liquid crystal display panel which can become partly opaque and partly transparent such that a transparent region of the panel serves as said aperture and control means for driving the liquid crystal panel so as to control the shape of the transparent region according to the particulars of the patterns on said reticle.

2. An apparatus according to Claim 1, wherein said control means comprises memory means for registering a plurality of different aperture shapes and command means for conforming the transparent region of the liquid crystal display panel with selected one of the registered aperture shapes.

3. An apparatus according to Claim 1, wherein said liquid crystal display panel is of a two-dimensional X-Y matrix type.

4. An apparatus according to Claim 1, wherein the transparent region of said liquid crystal display panel has an annular shape.
